# EUROPEAN PATENT APPLICATION

(11) **EP 4 498 164 A1**
(43) Date of publication of application: **29.01.2025**
(21) Application number: 23187158.3
(22) Date of filing: 24.07.2023
(51) Int. Cl.: G03F 9/00, G03F 7/20, G03F 1/84

(54) **SYSTEM AND METHOD FOR SUBSTRATE ALIGNMENT WITH IMAGE STITCHING WITH POSITION ERROR DETERMINATION AND CORRECTION**

(71) Applicant: ASML Netherlands B.V., 5500 AH Veldhoven (NL)
(72) Inventor: LOMANS, Bram, Antonius, Gerardus, 5500 AH Veldhoven (NL); JENKINS, Gregory, Warren, Wilton, CT 06897 (US)
(74) Representative: ASML Netherlands B.V.

(57) **Abstract**

The present disclosure provides a method of obtaining a substrate alignment image, comprising the steps of: arranging a substrate on a substrate stage, the substrate having at least a first marker at a respective first marker position; using an image sensor to acquire a first image of the substrate at a first position, the first position being at or near the first marker position; moving the substrate with respect to the image sensor or vice versa to a second position adjacent to the first position; determining a position error; using the image sensor to acquire a second image at the second position; correcting the second position of the second image using the position error; and stitching the second image to the first image taking into account the corrected second position of the second image, to provide a stitched image.

## Description

### FIELD

The present invention relates to a system and method for substrate alignment. The system and method may be included in, for instance, a lithographic apparatus or in a metrology or inspection system. The method and system may be used, for instance, to align wafers using alignment markers provided on the wafers.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

The lithographic apparatus comprises several movable components. For instance the wafer stage, a relatively heavy component for supporting a substrate, is moved over short distances and at a relatively fast rate between respective positions on the substrate. The latter allow irradiation of the same pattern on multiple positions on the substrate, typically arranged in a grid. Also, multiple layers may typically need to be arranged on the substrate, one on top of the other. The latter requires accurate positioning of the substrate before exposure, to minimize overlay error.

In addition to the drive towards smaller patterns and the associated requirement for positioning accuracy, semiconductor manufacturing processes involve a constant drive to increase throughput of the number of substrates, typically expressed as a number of substrates that can be processed per hour. As a result, accurate and fast positioning of the substrates are important aspects of the manufacturing process. Herein, accurate positioning may be involved in one or more steps in the process, for instance during exposure of subsequent layers on top of existing layers of an integrated circuit (IC). Alternatively, positioning may be involved in post-processing of the IC. Post-processing may include, but is not limited to, metrology processes for post-etch overlay measurement of multiple layers, measurement of critical dimensions (CD), and overall performance monitoring of products.

Applicant for instance markets metrology systems, including optical and e-beam wafer metrology and inspection products. These systems can typically quickly and accurately measure pattern quality before, during and after high-volume chip manufacturing. Some metrology systems offer measurements within the chip itself. One such system may be referred to as YieldStar^{™}. It is considerably faster than scanning electron microscope (SEM) solutions. YieldStar delivers excellent accuracy, helping chipmakers improve overlay performance and yield through after-etch process control.

A coarse and a fine wafer alignment (WA) step are used in YieldStar to determine the substrate position with respect to an optical sensor. The substrates typically comprise markings, also referred to as alignment markers, as a point of reference. Since the alignment markers often cannot be captured in one image, multiple subsequent images may be stitched. Stitching refers to the subsequent optical imaging of adjacent image sections on the substrate, for instance in a meandering pattern, and stitching these subsequent images to form a single image. The stitching steps are repeated until the respective alignment marker is included in the stitched image.

For instance, the wafer may be loaded onto the wafer stage with an accuracy within +/- 125 µm in the horizontal plane (x-y direction) and a rotational accuracy within +/- 560 µrad (Rz degree of freedom). Limitations and boundary conditions causing the error are, for instance, the accuracy of the wafer gripper, print errors on the wafer, and thermal drift. An alignment branch is typically used to determine the target position with respect to an optical sensor. As mentioned above, the alignment may be performed in two steps: 1) The coarse wafer alignment, wherein for instance two alignment markers are measured, typically close to the centre of the wafer; 2) The fine wafer alignment, where for instance six alignment markers are measured, for instance within a radius of 130 mm.

WO 2021/254810 A1 discloses a system including an illumination system, an optical element, a switching element and a detector. The illumination system includes a broadband light source that generates a beam of radiation. The dispersive optical element receives the beam of radiation and generates a plurality of light beams having a narrower bandwidth than the broadband light source. The optical switch receives the plurality of light beams and transmits each one of the plurality of light beams to a respective one of a plurality of alignment sensor of a sensor array. The detector receives radiation returning from the sensor array and to generate a measurement signal based on the received radiation..

US5739913 discloses a non-contact substrate alignment system for a lithography system that comprises three substrate edge detectors. Each edge detector comprises a projector, preferably located above the substrate, that projects a light field down onto a substrate and a stage. The light field has a predetermined shadow line that is straight and runs perpendicularly to the direction of the substrate's edge. A camera is also located above the substrate and detects the light from the light field. The height differential between the substrate and stage causes a shift in the shadow line from the perspective of the camera. A controller connected to the camera utilizes this shift to locate the edge of the substrate. The technique uses detectors and projectors that can be located entirely above the substrate.

The methods above typically require multiple substrate stage (WS) moves to find the respective alignment markers. Due to the mass of the stage, substrate stage moves are relatively slow and require time for the stage to settle after each move before the sensor can make a subsequent image. As such, these methods have inherent limitations to throughput and speed.

The present disclosure aims to provide a faster alignment system.

### SUMMARY

The disclosure provides a method of obtaining a substrate alignment image, comprising the steps of:
arranging a substrate on a substrate stage, the substrate having at least a first marker at a respective first marker position;
using an image sensor to acquire a first image of the substrate at a first position, the first position being at or near the first marker position;
moving the substrate with respect to the image sensor or vice versa to a second position adjacent to the first position;
determining a position error;
using the image sensor to acquire a second image at the second position;
correcting the second position of the second image using the position error; and
stitching the second image to the first image taking into account the corrected second position of the second image, to provide a stitched image.

In an embodiment, the step of determining a position error includes using an interferometric position sensor (IFM).

In an embodiment, the method comprises the steps of moving the substrate to a third position adjacent to the second position;
determining a substrate stage position error;
acquiring a third image at the third position;
correcting the third position using the substrate stage position error; and stitching the third image to the stitched image taking into account the corrected third position.

In another embodiment, the method comprises repeating the steps of acquiring a subsequent image and stitching the subsequent image to the stitched image, until the first marker is included in the stitched image.

In an embodiment, a time period between the steps of moving the substrate to a second position adjacent to the first position, determining the substrate stage position error, and acquiring the second image at the second position is smaller than a settling time of the substrate stage.

In an embodiment, the step of determining a substrate stage position error includes determining an average substrate stage position error that occurred during the step of acquiring a second image at the second position, and the step of correcting the second position of the second image using the position error including correcting the second position using the average substrate stage position error.

According to another aspect, the disclosure provides a position measurement system, adapted to the method as referenced above.

According to another aspect, the disclosure provides a position measurement system, comprising:
a substrate stage for holding a substrate , the substrate having at least a first marker at a first marker position;
an image sensor arranged above the substrate stage for taking an image of the substrate;
a position measurement system for determining a position of the substrate with respect to the image sensor, and being adapted for determining a position error;
wherein the image sensor is adapted for acquiring a first image of the substrate at a first position, the first position being at or near the first marker position, and for acquiring a second image when the substrate is at a second position; and
a processor adapted for correcting the second position of the second image using the position error, and for stitching the second image to the first image taking into account the corrected second position.

In an embodiment, the position measurement system includes an interferometric position sensor (IFM).

According to yet another aspect, the disclosure provides a lithographic apparatus, comprising at least one position measurement system as described above.

According to another aspect, the disclosure provides a metrology tool, comprising at least one position measurement system according to one of claims 7 to 9.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic side view of an alignment system;
- Figure 3 depicts a top view of an exemplary pattern of subsequent images, stitched to conjunctively form a larger image;
- Figure 4 depicts a top view of another exemplary pattern of subsequent images, stitched to conjunctively form a larger image;
- Figure 5 depicts a top view of two exemplary adjacent images, stitched to form a single image;
- Figure 6 depicts move exemplary profiles for a substrate stage moving between two positions; and
- Figure 7 depicts another exemplary pattern of subsequent images stitched conjunctively to form a larger image.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

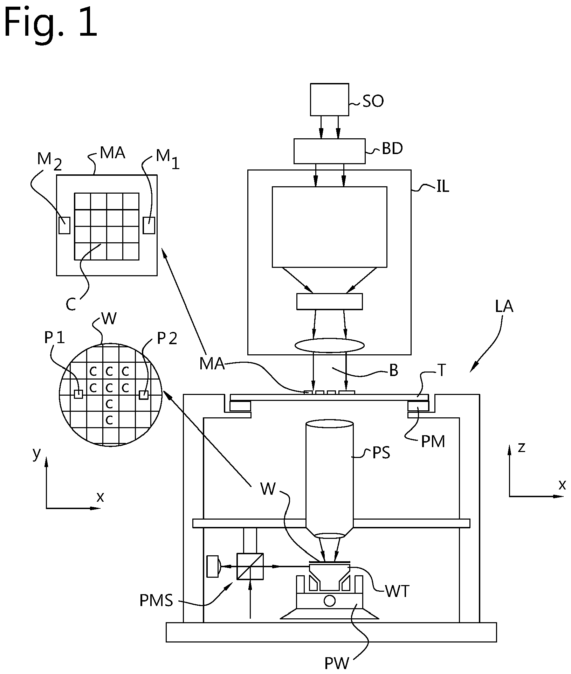

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

As depicted in Figure 1, the lithographic apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

Referring to FIG. 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask MA), which is held on the mask support structure (e.g., mask table MT), and is patterned by the patterning device. Having traversed the mask MA, the radiation beam B passes through the projection system PS, which focuses the beam onto a target portion C of the substrate W. With the aid of the second positioning device PW and position sensor IF (e.g. an interferometric device, linear encoder or capacitive sensor), the substrate table WT can be moved accurately, e.g. so as to position different target portions C in the path of the radiation beam B. Similarly, the first positioning device PM and another position sensor (which is not explicitly depicted in FIG. 1) can be used to accurately position the mask MA with respect to the path of the radiation beam B, e.g. after mechanical retrieval from a mask library, or during a scan.

Referring to Fig. 1, the mask table MT may have an associated first positioning device PM. Movement of the substrate table WT or "substrate support" may be realized using a second positioner PW. Each positioning device may include a long-stroke module and an associated short-stroke module. The latter may enable more accurate positioning, with respect to the long stroke module. In case the lithographic apparatus LA is a stepper (as opposed to a scanner), the mask table MT may be connected to a short-stroke actuator only, or may be fixed.

Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The lithographic apparatus could be used in at least one of the following modes:
1. In step mode, the mask table MT or "mask support" and the substrate table WT or "substrate support" are kept essentially stationary, while an entire pattern imparted to the radiation beam is projected onto a target portion C at one time (i.e. a single static exposure). The substrate table. WT or "substrate support" is then shifted in the X and/or Y direction so that a different target portion C can be exposed. In step mode, the maximum size of the exposure field limits the size of the target portion C imaged in a single static exposure.
2. In scan mode, the mask table MT or "mask support" and the substrate table WT or "substrate support" are scanned synchronously while a pattern imparted to the radiation beam is projected onto a target portion C (i.e. a single dynamic exposure). The velocity and direction of the substrate table WT or "substrate support" relative to the mask table MT or "mask support" may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT or "mask support" is kept essentially stationary holding a programmable patterning device, and the substrate table WT or "substrate support" is moved or scanned while a pattern imparted to the radiation beam is projected onto a target portion C. In this mode, generally a pulsed radiation source is employed and the programmable patterning device is updated as required after each movement of the substrate table WT or "substrate support" or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

The substrate table WT of FIG. 1 may be provided with a position measurement system PMS. The position measurement system measures a position of the substrate table WT. The position measurement system may be encoder based or interferometer based. For details of an interferometer system for position measurement, reference is made to, for instance, US2021072088.

In addition, the substrate table WT of Fig. 1 may be provided with additional actuators to enable movement in one or more degrees of freedom. A body has six degrees of freedom to define its position in a space: three translational degrees of freedom and three rotational degrees of freedom. The translational degrees of freedom are generally referred to as the directions x, y and z in a Carthesian coordinate system. The directions x, y and z and mutually perpendicular. The rotational degrees of freedom are generally referred to as the directions rx, ry and rz, wherein rx is a rotation with a rotation axis in the x direction, ry is a rotation with a rotation axis in the y direction and rz is a rotation with a rotation axis in the z direction.

The invention will be described herein below with respect to a substrate table WT. The substrate table itself may be included in various apparatus, including but not limited to a metrology tool, a lithographic apparatus LA, a YieldStar^{™} tool, a mask stage, a reticle stage.

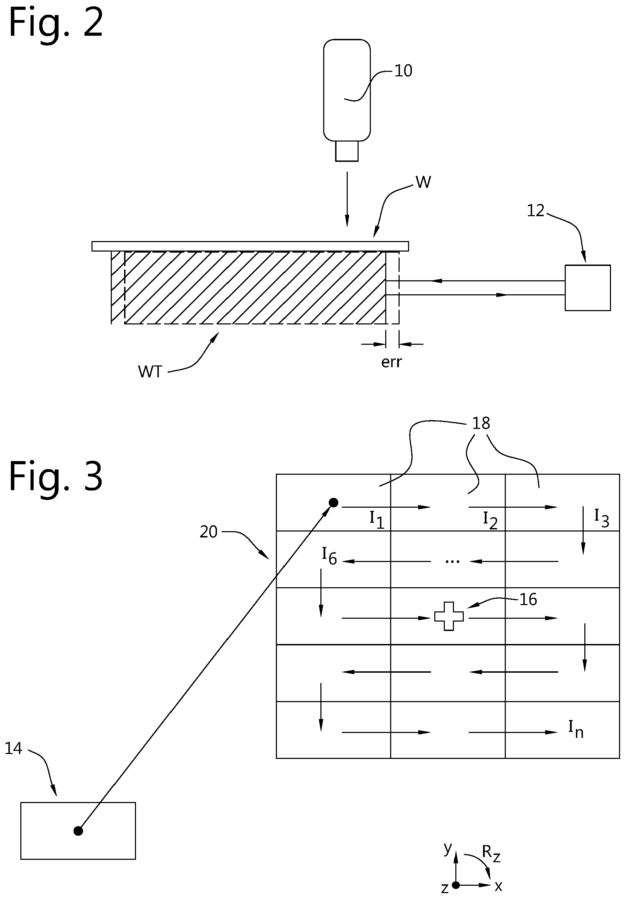

FIG. 2 shows the substrate table WT provided with a substrate W. An image sensor 10 may be provided to acquire images of the substrate W. A position sensor 12 may be provided to measure a position of the substrate table WT. The image sensor 10 may be an optical sensor, able to make optical images of the substrate. The position sensor 12 may be an interferometer.

Figure 3 shows an example of an image 14 obtained using the image sensor 10. The image has a certain size. Said size may be expressed as, for instance, a width and height, and/or a number of pixels. The image sensor may be an optical sensor. The sensor may be a CCD sensor (charge-coupled device). The size of the image 14 may be referred to as the field of view (FoV) of the image sensor 10.

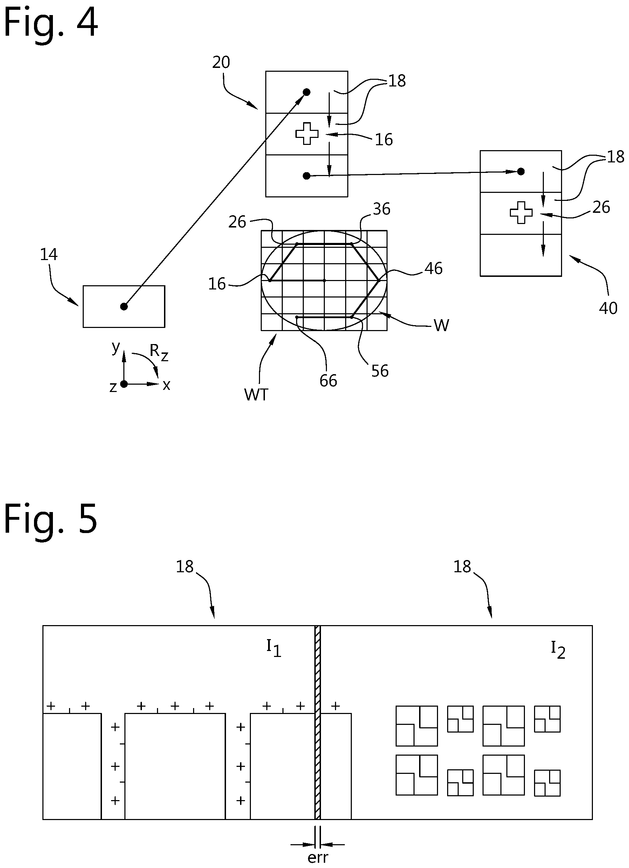

The field of view from the alignment branch is typically insufficient to capture the alignment mark 16 in one image, given the limited accuracy of the wafer load plus the size of the alignment marker 16. Herein, the required field of view is the size of the marker plus twice the wafer load error. Therefore, multiple images 14 are typically stitched to together form a larger composite image 20. Stitching is exemplified in Figures 3 and 4.

Image stitching or photo stitching is the process of combining multiple (optical) photographic images with overlapping fields of view to produce a single, larger image. Commonly performed through the use of computer software, most approaches to image stitching use exact overlaps between images and identical exposures to produce seamless results. Some stitching algorithms may benefit from differently exposed images by using high-dynamic-range imaging in regions of overlap.

As shown in Fig. 3, to find a first marker 16, the image sensor 10 is used to acquire multiple subsequent images 18. Each image is labelled I1, I2, ... In for subsequent images 1 to n, n being an integer. The images 18 are stitched together to form a single, larger, stitched image 20. The images 18 may be acquired along a certain pattern, for instance, a meandering pattern (Fig. 3), a linear pattern (Fig. 4), or a circular or spiralling pattern.

Figure 3 indicates that, for instance, 15 stitched images 18 may be required to find the first alignment marker 16. This may be a typical example for a first step referred to as coarse wafer alignment or coarse positioning. In the example, the pattern includes for instance three images 18 in x-direction and multiple, for instance five, images in y-direction.

Figure 4 provides a schematic example exemplifying fine position. Fine positioning typically includes finding a few other markers as well. The substrate W may, for instance, be provided with first marker 16, second marker 26, third marker 36, fourth marker 46, firth marker 56, and sixth marker 66. The substrate W may be provided with any number of markers, depending on wafer size or type.

Following the coarse positioning step, as exemplified in Figure 3, the position of the first marker 16 is typically known in more detail. Therefore, a limited number of images 18 may be required to find the first marker, and subsequently the second marker 26 and further markers, see Figure 4. For instance, one to three images 18 may be required to obtain a stitched image 30 containing the complete first marker 16. The number of required images 18 may depend on the size of the marker 16. Once the first marker has been located, the substrate table may move towards the position of the second marker 26. The image sensor 10 acquires one or more images 18 until the second marker 26 is in the composite image. If more than one image 18 is required, subsequent images 18 are stitched to obtain a second stitched image 40.

The method of the present disclosure can be used for coarse wafer alignment, but is also suitable for fine alignment.

The disadvantage of the alignment methods as described above, and especially of the coarse positioning, relate to the multiple moves of the substrate stage which are required. Although the moves are typically small, for instance in the order of 50 to 200 µm in the x-y direction, the substrate stage is relatively slow. The speed of the substrate stage is limited by, for instance, the way wherein a setpoint is generated. Herein, both acceleration and its higher order derivatives may be taken into account. In physics, jerk or jolt is the rate at which an object's acceleration changes with respect to time. Thus, jerk is the 3rd order derivative of position, and the 1st order derivative of acceleration. Jerk is a vector quantity (having both magnitude and direction). Jerk is most commonly denoted by the symbol j and expressed in m/s3 (SI units) or standard gravities per second (g0/s). Snap, also referred to as jounce, is the fourth derivative of the position vector with respect to time, or the rate of change of the jerk with respect to time. Equivalently, snap is the second derivative of acceleration or the third derivative of velocity.

The setpoint for moves of the substrate table WT may be generated using a fixed ratio for Jerk to Acceleration, for instance of 800 Hz, and a ratio of Snap to Jerk of 1.5 kHz Hz. For a fourth order setpoint, this means that the minimum move time can be determined with the following equation: 8TS + 4Tj = 18 ms, with TS is about 2 ms and Tj is about 1 ms. When also considering the wafer stage settling time, which may be in the order of a few milliseconds in both the x-direction and y-direction, for instance 7 to 15 ms, the minimum move time is in the order of about 30 ms for lateral movements in the x-y directions. Note that this is independent of the move distance. For an increasing move distance, the minimum move time will at a certain moment increase, but this is for millimeter level, not for micrometer level.

Generally referring to figures 2 and 5, the method of the present disclosure improves on the positioning steps as described above by:
1) Using the position sensor 12 of the substrate stage WT to measure the position of the substrate stage, and also to determine a position error ERR of the substrate stage with respect to a setpoint or reference, during the acquisition of the respective images 18; and
2) Using the position error ERR to correct the position of the acquired image 18.

Determining the position error ERR may be a function or functionality included in the position sensor 12. The position sensor 12 can measure the position of the substrate table WT. Please note that although Figure 2 shows a single position sensor 12, the substrate table may, in a practical embodiment, be provided with multiple position sensors 12, for instance one for linear position sensing in the x-direction and another sensor for linear position sensing in the y-direction. Additional position sensors may be provided for the height (z-direction) direction and/or for rotational directions.

When the substrate table must move from one position to another, an actuator connected to the substrate table is instructed to move the substrate table to the new position according to a setpoint. During and after the subsequent movement of the substrate table, the position sensor 12 measures the position of the substrate table. When the substrate table WT has reached its new position, the position sensor can determine a difference between the actual position of the substrate table and the setpoint position, as referenced above. Said difference is the position error ERR, as indicated in Fig. 2 or 5.

In the system and method of the present disclosure, the position error may be used in various ways. For instance, the position error may, for each linear direction of movement, be measured directly for each move. Alternatively, an average position error may be used. The position error may, for each linear direction of movement, be measured directly for each move. The position error could be calculated as the position error after wafer settling. Alternatively, the position error can be calculated as the average position error during settling of the substrate table if the image is taken while the substrate table is still moving. Thus, the position sensor 12 of the substrate stage WT is used to measure the position of the substrate stage, and also to determine a position error ERR of the substrate stage with respect to a position setpoint or reference, during the acquisition of the respective images 18. Said position error of the substrate stage is used to correct the setpoint position of the substrate. The latter corrected position is coupled to the image 18. The image, including its corrected position, is subsequently stitched to the previously available images, as described with respect to Figures 3 and 4.

Instead of determining the position error ERR during or after each move, the method may also determine an average position error during the move. I.e., the position error as sampled at respective times during the movement is averaged over the time of the move. The average position error may be used to correct the position of the acquired image 18. For instance, an average position error may be determined for each move of the substrate stage, either in x-direction, y-direction, and/or for rotation Rz around the vertical axis or z-axis.

The method of the disclosure will speed up wafer alignment. Especially coarse wafer alignment, which requires multiple stage moves, will speed up significantly. The method provides, for instance, the following advantages:
1) the settling time of the substrate stage after movement can be eliminated partly or entirely in the process of image stitching. I.e., although the substrate stage may have to settle after each move, due to the position correction according to the method of the disclosure, the related image can be acquired and processed immediately after the move of the substrate table, and does not have to wait until the substrate table has settled.
2) A variable jerk-to-acceleration ratio can be used during movement of the substrate stage. This will speed up movement. As a result, a significant throughput gain can be achieved, which is quantified herein below.

The present disclosure invention focuses on a method as an enabling technology for throughput improvement. The method may also be used to increase the accuracy of alignment. If a fixed jerk-to-acceleration ratio and settling time are followed according to the method of the present disclosure, the error adjusted for in the stitch will improve the stitching accuracy. Testing may indicate optimal values and trade-off between accuracy and speed, for instance when using a variable jerk-to-acceleration ratio, settling time of the substrate stage.

Before quantifying the throughput performance, please note the cause of the conventional setpoint generation requiring to have a fixed ratio for jerk-to-acceleration (J/A) and a fixed ratio of snap-to-jerk (S/J), and the relating relatively long move times for short moves of the substrate table. In high-end application, a typical controller for movement of a substrate stage is a non-linear HIGGS (Hybrid Integrator-Gain Systems) controller. To reduce the complexity of this type of controller, a fixed ratio for J/A and S/J can be used. The fixed ratio makes a negligible impact for moves larger than a few mm, because these moves are acceleration limited. In metrology applications, such as the YieldStar^{™} system referenced in the introduction, the majority of substrate stage moves are multi-mm (i.e. exceeding 1 mm in a certain direction of movement), so this method works well. However, relatively short moves of the substrate stage, as required for alignment, are limited by the jerk and snap.

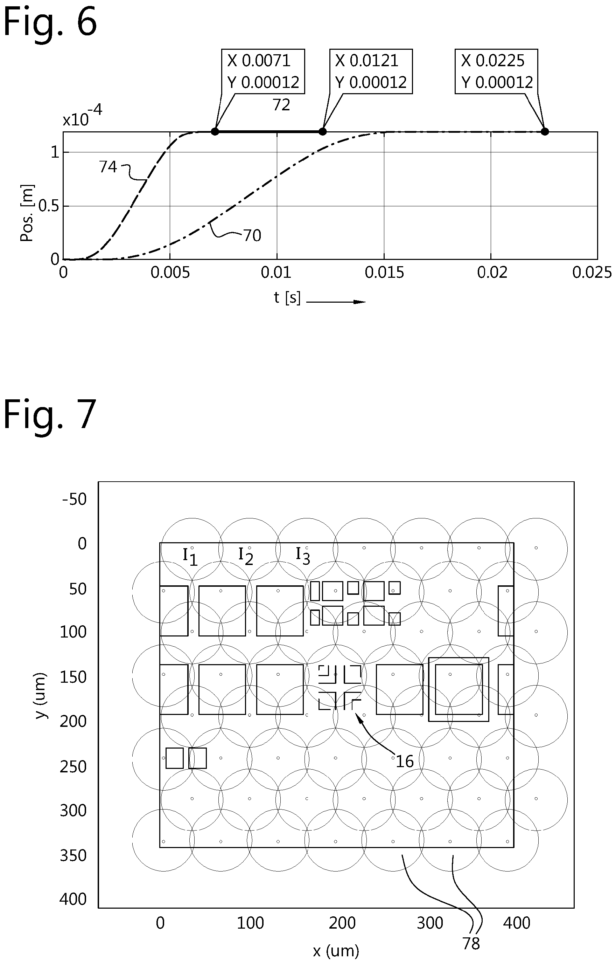

During the stitching of the images 18, the move in x-direction may be in the order of 100 to 150 µm. Figure 6 exemplifies the impact of variable or fixed ratio. In the diagram of Figure 6, the vertical axis indicates the position of the substrate stage (for instance, in µm), versus time t on the horizontal axis. Line 70 indicates a move of the substrate table using fixed ratios of J/A and S/J in the controller. Line 72 indicates a substrate stage move using a variable ratio for J/A and S/J in the controller, at a time wherein the substrate stage has also been able to settle in its new position. Line 74 indicates the region according to the method of the present disclosure. Line 74 is linked to line 72 and results from the controller using a variable ratio for J/A and S/J. However, as the position of the substrate stage is corrected using the position error ERR, as described above, the method does not have to wait for the substrate stage to settle.

As exemplified in Figure 6, and confirmed in similar tests and simulations for other degrees of freedom (y-axis, rotation), the method of the disclosure provides an improvement exceeding, for instance, at least 20 to 50%. The latter results from the difference in move time plus settle time. The substrate stage moves using a variable ratio for J/A and S/J and settle time take about 12 ms, while the move using a fixed ratio takes 23 ms (line 70).

In a further improvement, a variable setpoint can be used if the standard linear control is applied or for non-linear control. In other words, the method of the present disclosure will work with both non-linear HIGS controllers and standard linear controllers. The method is not controller specific, it may apply to any type of controller.

In both scenarios, a slightly larger settling time may be required to achieve a predetermined substrate stage accuracy (of, for instance, the order of 1 µm). However, with the method and system of the disclosure, it is not needed to achieve the required accuracy with the substrate stage, because the position error can be corrected (for instance, afterwards, in post-processing). Therefore, the time for the substrate stage to settle may be obviated entirely, i.e. no settling time is needed at all. The latter results in a move time of, for instance, only 7.1 ms instead of 22.5 ms, according to the example shown in Figure 6. For the corresponding move of the substrate stage in the y-direction, the 70 µm move can reduce to, for instance, 7.4 ms (using a variable ratio for J/A and S/J and obviating settling time) instead of 27.5 ms (using a fixed ratio for J/A and S/J and including settling of the stage after the move).

In the examples above, the setpoints used may be: a fixed ratio of J/A = 600 Hz and S/J = 1000 Hz and settling time; compared to a setpoint with variable ratio of J/A ≈ 300 HZ and S/J ≈ 1000 Hz and without settling time.

During the coarse wafer alignment, see the example of Figure 3, there may be 4 × 10 moves in x-direction and 4 × 4 moves in the y-direction. There are four acquisitions for only two targets because the first target requires three acquisitions, one at each wavelength for auto-dose color. The total reduction in move time per alignment marker equals: 4·10·(15.7 ms-7.1 ms) + 4·4·(20.7 ms-7.4 ms) = 557 ms.

To express this time reduction in terms of throughput, consider a practical example of six wafers with each 100 targets. The coarse alignment procedure occurs, for instance, about seven times in a certain job, namely, two times for the first wafer and five times for other five wafers. So, in total the method of the disclosure would save about 4 seconds, which is equivalent to a gain of about 4%.

The advantage and time reduction provided by the method of the disclosure becomes more important for future developments in metrology, wherein cameras with larger magnifications are envisaged. Larger magnifications give smaller field of views, yet such cameras typically reduce capital expenditure and complexity. Without modifications, such large magnification cameras have a significantly smaller field of view, and as a consequence would require more images and more stitching. The method of the disclosure will significantly reduce the corresponding time penalty, and thus help as an enabler for the new development.

A potential dark field camera, as currently on the market, may have a field of view limited to a 70-µm, circular field of view. The latter may differ for different camera size. See Figure 7 for an example.

A practical embodiment of a darkfield camera application is exemplified with reference to Figure 7. For throughput quantification, it is assumed that the entire field of view can be filled. The reduction in field of view due to the use of a darkfield camera instead of a regular optical camera increases the number of images 78 and subsequent stitches needed to find the marker 16. For instance, 56 images 78 may be needed to find four markers. The total move time to acquire all 56 images for four stitched images 80, to find four markers, may be: 4×(48×15.7 ms + 8×20.7 ms) = 3,7 ms.

With the new method and a variable J/A ratio, that time can be improved to 4×(48×7.1 ms + 8×7.4 ms) = 1,6 ms, an improvement exceeding 2,0 ms per substrate. Coarse alignment occurs multiple times per job, so the new method will save multiple times the above time period. For instance, seven coarse alignment steps may be required for alignment of a single substrate, saving more than 14 ms. The total throughput time (TPT) for the substrate will improve, providing a gain in the order of 10 to 15 %.

The example of Figure 7 shows a sampling scheme of an alignment field of view with the reduced dark field camera field of view. The field of view is indicated by the circles, indicating (potential) images 78. The simulation samples the full 390 µm by 340 µm field, which resembles a worst-case scenario wherein the entire field needs to be images to find the marker 16, for alignment with a camera having a circular field of view having a diameter of, for instance, 70 µm (indicated by the circles).

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of obtaining a substrate alignment image, comprising the steps of:
arranging a substrate on a substrate stage, the substrate having at least a first marker at a respective first marker position;
using an image sensor to acquire a first image of the substrate at a first position, the first position being at or near the first marker position;
moving the substrate with respect to the image sensor or vice versa to a second position adjacent to the first position;
determining a position error;
using the image sensor to acquire a second image at the second position;
correcting the second position of the second image using the position error; and
stitching the second image to the first image taking into account the corrected second position of the second image, to provide a stitched image.

2. The method of claim 1, the step of determining a position error including using an interferometric position sensor (IFM).

3. The method of claim 1 or 2, comprising the steps of
moving the substrate to a third position adjacent to the second position;
determining a substrate stage position error;
acquiring a third image at the third position;
correcting the third position using the substrate stage position error; and
stitching the third image to the stitched image taking into account the corrected third position.

4. The method of one of the previous claims, comprising repeating the steps of acquiring a subsequent image and stitching the subsequent image to the stitched image, until the first marker is included in the stitched image.

5. The method of one of the previous claims, wherein a time period between the steps of moving the substrate to a second position adjacent to the first position, determining the substrate stage position error, and acquiring the second image at the second position is smaller than a settling time of the substrate stage.

6. The method of one of the previous claims, the step of determining a substrate stage position error including determining an average substrate stage position error that occurred during the step of acquiring a second image at the second position, and the step of
correcting the second position of the second image using the position error including correcting the second position using the average substrate stage position error.

7. Position measurement system, adapted to the method of claim 1.

8. Position measurement system, comprising:
a substrate stage for holding a substrate , the substrate having at least a first marker at a first marker position;
an image sensor arranged above the substrate stage for taking an image of the substrate;
a position measurement system for determining a position of the substrate with respect to the image sensor, and being adapted for determining a position error;
wherein the image sensor is adapted for acquiring a first image of the substrate at a first position, the first position being at or near the first marker position, and for acquiring a second image when the substrate is at a second position; and
a processor adapted for correcting the second position of the second image using the position error, and for stitching the second image to the first image taking into account the corrected second position.

9. The system of claim 8, the position measurement system including an interferometric position sensor (IFM).

10. Lithographic apparatus, comprising at least one position measurement system according to one of claims 7 to 9.

11. Metrology tool, comprising at least one position measurement system according to one of claims 7 to 9.
